# EUROPÄISCHE PATENTANMELDUNG

(11) **EP 0 627 685 A1**
(43) Veröffentlichungstag der Anmeldung: **07.12.1994**
(21) Anmeldenummer: 93108733.2
(22) Anmeldetag: 30.05.1993
(51) Int. Cl.: G06F 11/26

(54) **Verfahren und Vorrichtung zum Testen von Komponenten eines Systems zur Übermittlung von Daten**

(71) Anmelder: International Business Machines Corporation, Armonk, N.Y. 10504 (US)
(72) Erfinder: Baer, Udo, W-6840 Lampertheim (DE); Mackert, Lothar, Dr., W-6903 Neckargemünd-Dilsberg (DE); Schneider, Jürgen M., Dr., W-6700 Ludwigshafen (DE); Stoll, Wilhelm, Dr., W-7520 Bruchsal 4 (DE); Zörntlein, Georg, Dr., W-6915 Dossenheim (DE)
(74) Vertreter: Schäfer, Wolfgang, Dipl.-Ing.

(57) **Zusammenfassung**

Es ist ein Verfahren und eine Vorrichtung zum Testen von Komponenten eines Systems zur Übermittlung von Daten von einem ersten Rechnersystem zu einem zweiten Rechnersystem beschrieben. Die Daten werden über ein Übermittlungssystem gesendet und empfangen. Zum Zwecke des Sendens und des Empfangens ist in den angeschlossenen Rechnersystemen ein Testwerkzeug enthalten, in dem die zugehörigen Befehle abgearbeitet werden. Die Befehle stellen eine Testbeschreibung dar und werden vorab von einem Benutzer in das Testwerkzeug eingegeben. Im Unterschied zum bekannten Stand der Technik, bei dem die Befehle vor Testablauf kompiliert werden, werden die Befehle erfindungsgemäß erst während des Testablaufs interpretativ verarbeitet, das heißt, es erfolgt erst während des Testablaufs eine Umsetzung der Befehle in die entsprechenden Funktionen. Dies hat den Vorteil, daß ein Benutzer während des Testablaufs die Befehle und die Daten ändern und/oder erweitern kann.

## Beschreibung

Die Erfindung betrifft ein Verfahren und eine Vorrichtung zum Testen von Komponenten eines Systems zur Übermittlung von Daten von einem ersten zu einem zweiten Rechnersystem, wobei die Übermittlung der Daten zu Testzwecken durch Abarbeitung von Befehlen einer Testbeschreibung erfolgt.

Derartige Verfahren und Vorrichtungen sind bekannt und werden dazu verwendet, bestimmte Komponenten des Übermittlungssystems, beispielsweise eine neu eingerichtete Adapterkarte oder neu installierte Übertragungsprogramme auf ihre korrekte Arbeitsweise zu überprüfen. Zu diesem Zweck enthält das erste Rechnersystem ein Testprogramm mit einer Anzahl von Befehlen. Die Befehle stellen eine Testbeschreibung dar und legen den Ablauf des Tests fest. Das erste Rechnersystem ist über das Übermittlungssystem mit dem zweiten Rechnersystem verbunden. Auch in dem zweiten Rechnersystem ist ein Testprogramm enthalten, das ebenfalls eine Anzahl Befehle einer Testbeschreibung aufweist.

Es wird nun angenommen, daß in das Übermittlungssystem eine neue Komponente, beispielsweise eine neue Adapterkarte aufgenommen worden ist. Zum Testen der korrekten Arbeitsweise der neuen Komponente werden die beiden Testprogramme in den angeschlossenen beiden Rechnersystemen abgearbeitet. Die Programme sind derart aufeinander abgestimmt, daß beispielsweise das erste Rechnersystem bestimmte Daten an das zweite Rechnersystem sendet, wobei das zweite Rechnersystem diese Daten kennt. Dadurch kann das zweite Rechnersystem die empfangenen Daten mit den bekannten Daten vergleichen und somit die korrekte oder fehlerhafte Arbeitsweise des Übermittlungssystems feststellen. Ein derartiger Test kann selbstverständlich auch in umgekehrter Richtung erfolgen sowie mit unterschiedlichen Daten.

Damit die Programme auf dem ersten und zweiten Rechnersystem ablaufen können, müssen sie zuerst programmiert werden. Zu diesem Zweck werden die gewünschten Testbeschreibungen in sogenannten Testbeschreibungssprachen von einem Programmierer in die Rechnersysteme eingegeben. Diese Testbeschreibungssprachen sind bei den aus dem Stand der Technik bekannten Verfahren und Vorrichtungen spezifisch auf den jeweiligen Anwendungsfall ausgerichtet und somit zumeist nicht standarisiert und damit nicht einheitlich. Die auf diese Weise programmierte Testbeschreibung wird dann vor dem Test mit Hilfe eines Übersetzungsprogrammes (Compiler) in eine sogenannte Maschinensprache umgesetzt (kompiliert), mit der unmittelbar das Rechnersystem gesteuert wird. Diese Maschinensprache ist nur für das Rechnersystem gedacht, nicht jedoch für den Programmierer. Sis ist deshalb für den Programmierer nur schwer lesbar oder nachvollziehbar. Ist am Ende eines Tests die gesamte programmierte Testbeschreibung auf beiden Rechnersystemen durchlaufen worden, so kann anhand von Testprotokollen überprüft werden, ob das Übermittlungssystem korrekt oder fehlerhaft gearbeitet hat. Aus diesen Testprotokollen können dann auch noch weitergehende Informationen entnommen werden, beispielsweise bei welchen Befehlen oder unter welchen sonstigen Bedingungen Fehler aufgetreten sind.

Der Programmierer kann daraufhin einerseits versuchen, den Fehler in dem Übermittlungssystem zu beheben, andererseits kann nunmehr auch die Testbeschreibung geändert und beispielsweise im Hinblick auf ein weiteres Eingrenzen eines aufgetretenen Fehlers verbessert werden.

Derartige aus dem Stand der Technik bekannte Verfahren und Vorrichtungen zum Testen von Komponenten eines Systems zur Übermittlung von Daten sind äußerst unflexibel. So ist es beispielsweise nicht möglich, während des eigentlichen Testablaufs irgendwelche bereits vorhandene Ergebnisse des Tests abzufragen oder während des Testablaufs die Testbeschreibung und damit den Testablauf als solchen zu verändern. Ebenfalls hat die spezifische Anpassung der Testbeschreibung an den jeweiligen Anwendungsfall zur Folge, daß bei jedem neuen Anwendungsfall die gesamte Testbeschreibung neu programmiert werden muß.

Aufgabe der Erfindung ist es, ein Verfahren und eine Vorrichtung zum Testen von Komponenten eines Systems zur Übermittlung von Daten zu schaffen, die insbesondere hinsichtlich der Bedienung verbessert ist.

Die Erfindung löst diese Aufgabe dadurch, daß bei einem Verfahren der eingangs genannten Art die Befehle der Testbeschreibung während des Tests interpretativ verarbeitet werden. Bei einer Vorrichtung der eingangs genannten Art wird die Aufgabe erfindungsgemäß dadurch gelöst, daß ein Aktionsmodul zur interpretativen Verarbeitung der Befehle der Testbeschreibung vorgesehen ist.

Abweichend vom Stand der Technik werden also die Befehle der Testbeschreibung nicht in ihrer Gesamtheit als Programm zeitlich vor dem eigentlichen Testablauf mit Hilfe eines Übersetzungsprogramms in Maschinensprache übersetzt, sondern die einzelnen Befehle werden im Moment ihrer Verarbeitung in die entsprechenden Funktionen umgesetzt. Der Programmierer hat dadurch die Möglichkeit, die noch in der Testbeschreibungssprache vorliegenden Befehle während des Testablaufs zu verändern. Es besteht somit die Möglichkeit, den Testablauf sofort an bereits vorhandene Ergebnisse des Tests optimal anzupassen. Ebenfalls ist es möglich, auf diese Weise weitere Befehle einzufügen und damit während des Testablaufs den Test zu erweitern. Im Vergleich zu den aus dem Stand der Technik bekannten Verfahren und Vorrichtungen wird durch die Erfindung die Bedienung des Tests wesentlich vereinfacht sowie die Flexibilität wesentlich erhöht. Des weiteren werden aufgrund der Änderungs- und Erweiterungsmöglichkeiten unnötige Testdurchläufe vermieden, so daß auch die Effektivität des gesamten Tests erhöht wird.

Bei einer Ausgestaltung der Erfindung, die auch eine eigenständige Erfindung darstellen kann, werden die Daten und die das Übermittlungssystem betreffenden Informationen unabhängig voneinander verwaltet. Durch diese Trennung wird erreicht, daß die Erfindung unabhängig wird von spezifischen, anwendungsabhängigen Testbeschreibungssprachen. Ebenfalls ist es dadurch möglich, daß dieselbe Testbeschreibung für verschiedene Anwendungsfälle, insbesondere auch für unterschiedliche Realisierungen von Übermittlungsprotokollen und Übermittlungskonfigurationen verwendet werden kann. Durch die Trennung der Daten der Übermittlung sowie der Informationen, die das Übermittlungssystem betreffen, wird der gesamte Test also anwendungsunabhängig. Durch die Ausgestaltung wird somit die Bedienerfreundlichkeit und die Flexibilität erhöht.

Weitere Ausgestaltungen und Weiterbildungen der Erfindung ergeben sich aus der nachfolgenden Beschreibung eines Ausführungsbeispiels der Erfindung, das in der Zeichnung dargestellt ist. Dabei zeigen
- Fig. 1: ein schematisches Blockschaltbild eines Ausführungsbeispiels einer erfindungsgemäßen Vorrichtung zum Testen der Übermittlung von Daten,
- Fig. 2: ein schematisches Blockschaltbild eines Testaufbaus für die erfindungsgemäße Vorrichtung der Fig. 1 mit zwei Rechnersystemen und einem Übermittlungssystem sowie
- Fig. 3: eine Anzahl von Befehlen einer Testbeschreibung für den Testaufbau der Fig. 2 mit den zugehörigen Erläuterungen.

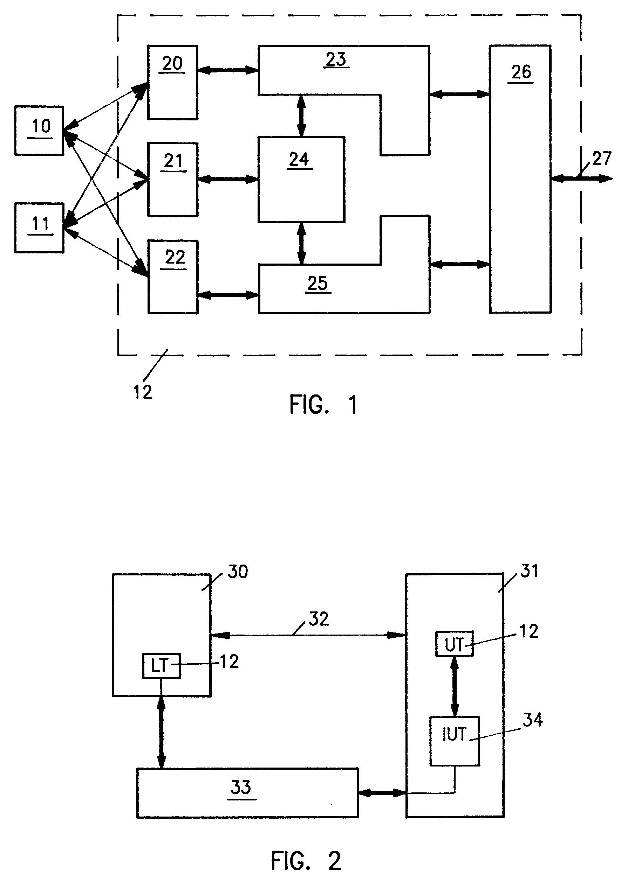

Bei dem in der Fig. 2 dargestellten Testaufbau ist ein erstes Rechnersystem 30 über ein Netzwerk 33 mit einer zu testenden Komponente 34 (Implementation under Test IUT) eines zweiten Rechnersystems 31 verbunden. Über das Netzwerk 33 können beliebige Daten in beiden Richtungen zwischen dem ersten Rechnersystem 30 und dem zweiten Rechnersystem 31 ausgetauscht werden.

Bei dem ersten und dem zweiten Rechnersystem 30, 31 kann es sich um bekannte Computersysteme mit bekannten Ein- und Ausgabeeinrichtungen und dergleichen handeln. Bei dem Netzwerk 33 kann es sich beispielsweise um ein sogenanntes "Local Area Network (LAN)" oder auch um ein Telefonnetzwerk handeln. Die zu testende Komponente 34 kann beispielsweise eine neue Adapterkarte oder ein neues Programm zur Datenübertragung sein.

Für den Test der zu testenden Komponente 34 ist es erforderlich, daß über das Netzwerk 33 und die genannte Komponente 34 Daten übermittelt werden und danach die korrekte Arbeitsweise der zu testenden Komponente 34 anhand der übermittelten Daten überprüft wird. Zu diesem Zweck ist in dem ersten und dem zweiten Rechnersystem 30, 31 ein Testwerkzeug 12 enthalten, das üblicherweise als Software, also in der Form von programmierten Befehlen vorhanden ist. Dieses Testwerkzeug 12 ist in der Fig. 1 näher dargestellt.

Im ersten Rechnersystem 30 ist das Testwerkzeug 12 als Lower Tester (LT) und im zweiten Rechnersystem 31 als Upper Tester (UT) bezeichnet. Für eine eventuell erforderliche Synchronisation der beiden Testwerkzeuge 12 (LT, Lower Tester und UT, Upper Tester) ist eine Verbindungsleitung 32 vorgesehen.

Das in der Fig. 1 gezeigte Testwerkzeug 12 weist ein Konfigurationseingabemodul 20, ein Testeingabemodul 21, ein Dateneingabemodul 22, ein Wegewahlmodul 23, ein Aktionsmodul 24, ein Datenverwaltungsmodul 25 und ein Schnittstellenmodul 26 auf. Das Konfigurationseingabemodul 20 ist mit dem Wegewahlmodul 23 verbunden, das Testeingabemodul 21 mit dem Aktionsmodul 24 und das Dateneingabemodul 22 mit dem Datenverwaltungsmodul 25. Des weiteren sind das Wegewahlmodul 23, das Aktionsmodul 24 und das Datenverwaltungsmodul 25 jeweils miteinander gekoppelt. Schließlich sind das Wegewahlmodul 23 und das Datenverwaltungsmodul 25 jeweils mit dem Schnittstellenmodul 26 verbunden.

Nach außen ist das Testwerkzeug 12 mit wenigstens einer Eingabestation 10 und wenigstens einem Speicher 11 verbunden, und zwar derart, daß das Konfigurationseingabemodul 20, das Testeingabemodul 21 und das Dateneingabemodul 22 jeweils direkt mit der Eingabestation 10 und dem Speicher 11 gekoppelt sind. Des weiteren ist ausgangsseitig eine Schnittstelle 27 vorgesehen, die an das Schnittstellenmodul 26 angeschlossen ist.

Über das Konfigurationseingabemodul 20 kann ein Benutzer die Informationen für eine bestimmte Testkonfiguration in das Testwerkzeug 12 einbringen. Durch diese Informationen werden insbesondere die Schnittstellen des ersten und des zweiten Rechnersystems 30, 31 festgelegt. Des weiteren werden durch diese Informationen sogenannte Beobachtungs- und Kontrollpunkte (Points of Control and Observation, PCOs) sowie sogenannte Interaktionspunkte (Coordination Points, CPs) definiert, mit deren Hilfe die Übermittlung unter anderem über die zu testende Komponente 34 geführt werden kann. Die in das Konfigurationseingabemodul 20 eingegebenen Informationen legen somit im vorliegenden Fall fest, in welcher Konfiguration das erste und das zweite Rechnersystem 30, 31 miteinander kommunizieren. Ebenfalls ist es mit Hilfe des Konfigurationseingabemoduls 20 möglich, bereits vorhandene Informationen anzuzeigen und zu bearbeiten, insbesondere zu ändern und/oder zu erweitern.

Durch das Testeingabemodul 21 kann ein Benutzer Befehle einer Testbeschreibung in das Testwerkzeug 12 eingeben. Vorzugsweise ist für diese Eingabe die Testbeschreibungssprache TTCN (Tree and Tabular Combined Notation), insbesondere die Repräsentationsformen TTCN.GR und TTCN.MP dieser Testbeschreibungssprache vorgesehen. Mit Hilfe des Testeingabemoduls 21 ist es somit für einen Benutzer möglich, einen Testablauf zu erstellen und in das Testwerkzeug 12 einzugeben. Ebenfalls ist es mit Hilfe des Testeingabemoduls 21 möglich, in dem Testwerkzeug 12 vorhandene Tests einem Benutzer anzuzeigen, so daß dieser die angezeigten Testabläufe bearbeiten, insbesondere ändern und/oder erweitern kann.

Durch das Dateneingabemodul 22 kann ein Benutzer Daten in das Testwerkzeug 12 eingeben, die später zu Testzwecken übermittelt werden sollen. Vorzugsweise basiert die Eingabe dieser Daten auf der Basis der Datenbeschreibungssprache ASN.1 (Abstract Syntax Notation 1). Ebenfalls ermöglicht das Dateneingabemodul 22, daß bereits in dem Testwerkzeug 12 vorhandene Daten einem Benutzer angezeigt und von diesem dann bearbeitet, insbesondere geändert und/oder erweitert werden können.

Die Eingabe der Informationen für das Konfigurationseingabemodul 20, der Befehle für das Testeingabemodul 21 und der Daten für das Dateneingabemodul 22 erfolgt mit Hilfe der Eingabestation 10. Im Speicher 11 sind die erforderlichen Programme zur Verarbeitung der Testbeschreibungssprache TTCN und der Datenbeschreibungssprache ASN.1 enthalten. Werden Informationen, Befehle oder Daten, die bereits in dem Testwerkzeug 12 vorhanden sind, an den Benutzer ausgegeben, so erfolgt dies vorzugsweise mit Hilfe eines Bildschirms der Eingabestation 10.

Das Konfigurationseingabemodul 20, das Testeingabemodul 21 und das Dateneingabemodul 22 dienen dazu, daß ein Benutzer mit dem Testwerkzeug 12 kommunizieren kann, daß also eine Ein- und Ausgabe von Informationen, Befehlen und Daten möglich ist. Eine Umsetzung dieser Informationen, Befehle und Daten erfolgt in dem Konfigurationseingabemodul 20, dem Testeingabemodul 21 und dem Dateneingabemodul 22 nicht. Es erfolgt nur ein Austausch der Informationen zwischen dem Konfigurationseingabemodul 20 und dem Wegewahlmodul 23, bzw. der Befehle zwischen dem Testeingabemodul 21 und dem Aktionsmodul 24, bzw. der Daten zwischen dem Dateneingabemodul 22 und dem Datenverwaltungsmodul 25. Erst in dem Wegewahlmodul 23, dem Aktionsmodul 24 und dem Datenverwaltungsmodul 25 erfolgt die Umsetzung dieser Informationen, Befehle und Daten in die entsprechenden Funktionen.

Das Wegewahlmodul 23 verwaltet alle Informationen über die Konfiguration des Testaufbaus, wie er in der Fig. 2 gezeigt ist, sowie die erforderlichen Informationen über die Schnittstellen der beteiligten Rechnersysteme 30, 31. Das Wegewahlmodul 23 ist jedoch so aufgebaut, daß es nicht an eine bestimmte Konfiguration eines Testaufbaus oder an bestimmte Schnittstellen von Rechnersystemen angepaßt ist, sondern daß verschiedenartige Konfigurationen und Schnittstellen in dem Wegewahlmodul 23 verarbeitet werden können.

Das Aktionsmodul 24 hat die Aufgabe, die von einem Benutzer in das Testeingabemodul 21 eingegebenen Befehle zu verarbeiten. In Abhängigkeit von den Befehlen stößt das Aktionsmodul 24 zugehörige Funktionen in dem Wegewahlmodul 23 und dem Datenverwaltungsmodul 25 an. Durch diese angestoßenen Funktionen werden dann die vorhandenen Befehle über das Wegewahlmodul und das Datenverwaltungsmodul letztendlich ausgeführt. Das Aktionsmodul 24 stellt somit eine Steuerungseinrichtung dar, die Befehle interpretiert, davon abhängige Funktionen initiiert und deren Ausführung kontrolliert.

Das Datenverwaltungsmodul 25 verwaltet die von einem Benutzer in das Dateneingabemodul 22 zu Testzwecken eingegebenen Daten. Die Daten werden in allgemeiner Weise verwaltet, sind also nicht auf eine bestimmte Konfiguration des Testaufbaus zugeschnitten. Des weiteren werden die Daten von dem Datenverwaltungsmodul 25 in diejenigen Codierungen umgesetzt, die für die Übermittlung in den jeweiligen Testaufbauten erforderlich sind.

Mit Hilfe des Schnittstellenmoduls 26 wird der Übergang von den allgemein gehaltenen Funktionen des Testwerkzeugs 12 zu dem speziellen Testaufbau realisiert. Das Schnittstellenmodul 26 paßt also die Schnittstelle 27 des Testwerkzeugs 12 an den jeweiligen Testaufbau an. Das Schnittstellenmodul 26 ist somit das einzige Modul, das bei einer Änderung der Konfiguration des Testaufbaus oder der Schnittstellen der beteiligten Rechnersysteme geändert werden muß.

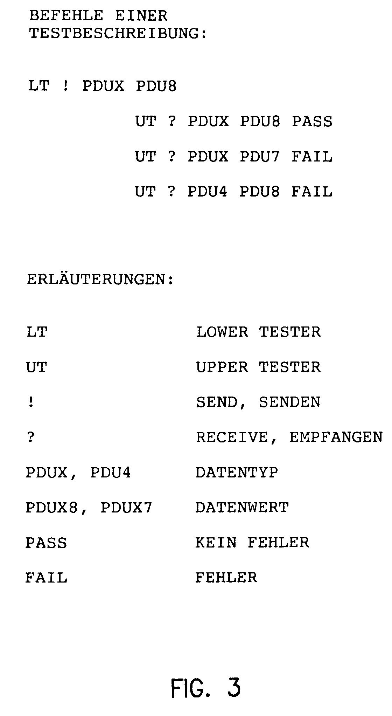

Nachfolgend wird die Funktion des Testwerkzeugs 12 anhand der vier in Fig. 3 aufgelisteten Befehle näher erläutert. Zugrundegelegt ist dabei ein Testaufbau, wie er in der Fig. 2 dargestellt ist. Die Informationen hinsichtlich der Konfiguration des Testaufbaus und der Schnittstellen zu den beiden Rechnersystemen 30, 31 sind bereits in dem Wegewahlmodul 23 enthalten. Ebenfalls sind die für die Befehle erforderlichen Daten in Form von Datentypen und Datenwerten in dem Datenverwaltungsmodul 25 bereits enthalten.

Die in Fig. 3 aufgelisteten Befehle werden von beiden Rechnersystemen 30, 31 etwa zeitgleich abgearbeitet. Die Befehle werden zu diesem Zweck jeweils nacheinander von dem Testeingabemodul 21 in das Aktionsmodul 24 eingelesen und dort verarbeitet. Der zweite, dritte und vierte Befehl stellen Alternativen dar, die sequentiell nach dem ersten Befehl bearbeitet werden. Die in den Befehlen verwendeten Bezeichnungen sind ebenfalls in Fig. 3 erläutert.

Der erste Befehl "LT ! PDUX PDUX8" hat die Bedeutung, daß das erste Rechnersystem 30 (LT, Lower Tester) einen bestimmten Datenwert (PDUX8) eines bestimmten Datentyps (PDUX) senden (!) soll. Das Testwerkzeug 12 des ersten Rechnersystems 30 führt diesen Befehl folgendermaßen durch:
Der Auftrag zum Senden wird von dem Aktionsmodul 24 an das Wegewahlmodul 23 weitergeleitet, so daß dieses alle Maßnahmen und Funktionen ergreifen kann, die für das Senden von Daten erforderlich sind. Den bestimmten Datenwert "PDUX8" und den bestimmten Datentyp "PDUX" gibt das Aktionsmodul 24 an das Datenverwaltungsmodul 25 weiter. Dieses stellt daraufhin die zu diesen Daten gehörigen Codierungen zur Verfügung. Angestoßen durch das Aktionsmodul 24 werden daraufhin vom Wegewahlmodul 23 die für die Übermittlung erforderlichen Informationen und vom Datenverwaltungsmodul 25 die zu übermittelnden codierten Daten an das Schnittstellenmodul 26 weitergegeben und von diesem dann über die Schnittstelle 27 versendet.

Während der erste Befehl nur das Testwerkzeug 12 (LT, Lower Tester) des ersten Rechnersystems 30 betrifft und aus diesem Grund das zweite Rechnersystem 31 keine Aktionen durchführt, richten sich die nachfolgenden drei Befehle nur an das Testwerkzeug 12 (UT, Upper Tester) des zweiten Rechnersystems 31, so daß in diesem Fall das erste Rechnersystem 30 diese Befehle nicht verarbeitet.

Der zweite Befehl "UT ? PDUX PDUX8 PASS" hat die Bedeutung, daß das zweite Rechnersystem 31 (UT, Upper Tester) einen bestimmten Datenwert (PDUX8) eines bestimmten Datentyps (PDUX) empfangen soll. Ist dies der Fall, so ist der Test erfolgreich beendet (Testurteil: PASS), ansonsten soll eine Fehlerbehandlung stattfinden (Testurteil: FAIL des dritten und des vierten Befehls).

Der zweite Befehl der Fig. 3 wird von dem Testwerkzeug 12 des zweiten Rechnersystems 31 wie folgt verarbeitet:
Das Aktionsmodul 24 teilt dem Wegewahlmodul 23 mit, daß Daten empfangen werden sollen. Das Wegewahlmodul 23 trifft daraufhin alle Vorkehrungen, die erforderlich sind, um Daten zu empfangen. Etwa zeitgleich teilt das Aktionsmodul 24 dem Datenverwaltungsmodul 23 die Daten mit, die zum Empfang vorgesehen sind. Bei diesen Daten handelt es sich um den bestimmten Datenwert "PDUX8" des bestimmten Datentyps "PDUX". Werden nun diese Daten von dem Schnittstellenmodul 26 empfangen und an das Datenverwaltungsmodul 25 weitergegeben, so teilt daraufhin das Datenverwaltungsmodul 25 dem Aktionsmodul 24 mit, daß die erwarteten Daten empfangen worden sind. Der Test ist damit beendet.

Bei dem dritten Befehl "UT ? PDUX PDUX7 FAIL" und dem vierten Befehl "UT ? PDUY PDUX8 FAIL" unterscheiden sich im dritten Befehl der Datenwert (PDUX7) und im vierten Befehl der Datentyp (PDUY) von dem Datenwert (PDUX8) und dem Datentyp (PDUX) des ersten Befehls, also den Daten, die gesendet werden. Empfängt somit das zweite Rechnersystem 31 Daten, wie sie in dem dritten oder dem vierten Befehl angegeben sind, so war die Übermittlung der Daten fehlerhaft. Der Test war damit nicht erfolgreich, was zur Folge hat, daß eine Fehlerbehandlung gestartet wird.

Durch Stop-Befehle oder dergleichen ist es möglich, den Testablauf an einer bestimmten Stelle anzuhalten. Ein Benutzer kann dann prüfen, welche Ergebnisse der Test bisher erzeugt hat. Des weiteren ist es dem Benutzer möglich, weitere Befehle über das Testeingabemodul 21 in das Testwerkzeug 12 einzugeben oder vorhandene Befehle zu ändern. Ebenfalls ist es dem Benutzer möglich, weitere Daten über das Dateneingabemodul 22 einzugeben oder vorhandene Daten zu ändern. Durch entsprechende Maßnahmen kann dann der Benutzer den geänderten oder erweiterten Test fortsetzen.

Soll das Testwerkzeug 12 in einer anderen Umgebung, also mit einer anderen Konfiguration des Testaufbaus und/oder mit anderen Schnittstellen zu den angeschlossenen Rechnersystemen betrieben werden, so kann ein Benutzer diese Änderungen, falls erforderlich sogar während eines Tests über das Konfigurationseingabemodul 20 in das Testwerkzeug 12 eingeben. In diesem Fall ist es meist jedoch zuzätzlich noch erforderlich, daß das Schnittstellenmodul 26 ebenfalls an die geänderte Konfiguration des Testaufbaus angepaßt wird. Dies kann beispielsweise durch ein Umstecken oder Umprogrammieren von Adapterkarten oder durch ein Umschalten zwischen verschiedenen Adapterkarten erfolgen.

Wesentlich ist, daß die über das Testeingabemodul 21 eingegebenen Befehle von dem Aktionsmodul 24 während des Testablaufs bearbeitet werden. Das Testwerkzeug 12 arbeitet deshalb nicht auf der Grundlage einer vorherigen Kompilierung der Befehle, sondern auf der Basis einer Interpretation der Befehle während des Tests.

Zusammengefaßt ist ein Verfahren und eine Vorrichtung zum Testen von Komponenten eines Systems zur Übermittlung von Daten von einem ersten Rechnersystem zu einem zweiten Rechnersystem beschrieben. Die Daten werden über ein Übermittlungssystem gesendet und empfangen. Zum Zwecke des Sendens und des Empfangens ist in den angeschlossenen Rechnersystemen ein Testwerkzeug enthalten, in dem die zugehörigen Befehle abgearbeitet werden. Die Befehle stellen eine Testbeschreibung dar und werden vorab von einem Benutzer in das Testwerkzeug eingegeben. Im Unterschied zum bekannten Stand der Technik, bei dem die Befehle vor Testablauf kompiliert werden, werden die Befehle erfindungsgemäß erst während des Testablaufs interpretativ verarbeitet, das heißt, es erfolgt erst während des Testablaufs eine Umsetzung der Befehle in die entsprechenden Funktionen. Dies hat den Vorteil, daß ein Benutzer während des Testablaufs die Befehle und die Daten ändern und/oder erweitern kann.

## Patentansprüche

1. Verfahren zum Testen von Komponenten eines Systems zur Übermittlung von Daten von einem ersten (30) zu einem zweiten Rechnersystem (31), wobei die Übermittlung der Daten zu Testzwecken durch Abarbeitung von Befehlen (Fig. 3) einer Testbeschreibung erfolgt, dadurch gekennzeichnet, daß die Befehle der Testbeschreibung während des Tests interpretativ verarbeitet werden.

2. Verfahren nach Anspruch 1, dadurch gekennzeichnet, daß die Daten und die das Übermittlungssystem betreffenden Informationen unabhängig voneinander verwaltet werden.

3. Verfahren nach Anspruch 1 oder 2, dadurch gekennzeichnet, daß aus den Daten und den das Übermittlungssystem betreffenden Informationen in Abhängigkeit von den Befehlen der Testbeschreibung die zugehörigen zu übermittelnden Daten und die zugehörigen, das Übermittlungssystem betreffenden Informationen ausgewählt werden.

4. Verfahren nach Anspruch 3, dadurch gekennzeichnet, daß die zu übermittelnden Daten und die das Übermittlungssystem betreffenden Informationen an das Übermittlungssystem (33, 34 über 27) ausgegeben werden.

5. Vorrichtung zum Testen von Komponenten eines Systems zur Übermittlung von Daten von einem ersten (30) zu einem zweiten Rechnersystem (31), wobei die Übermittlung der Daten zu Testzwecken durch Abarbeitung von Befehlen (Fig. 3) einer Testbeschreibung erfolgt, dadurch gekennzeichnet, daß ein Aktionsmodul (24) zur interpretativen Verarbeitung der Befehle der Testbeschreibung vorgesehen ist.

6. Vorrichtung nach Anspruch 5, dadurch gekennzeichnet, daß ein Datenverwaltungsmodul (25) zur Verwaltung der Daten vorgesehen ist, sowie eine Wegewahlmodul (23) zur Verwaltung der das Übermittlungssystem betreffenden Informationen, wobei das Datenverwaltungsmodul (25) und das Wegewahlmodul (23) mit dem Aktionsmodul (24) jeweils gekoppelt ist.

7. Vorrichtung nach Anspruch 5 oder 6, dadurch gekennzeichnet, daß ein Testeingabemodul (21) zur Eingabe der Befehle der Testbeschreibung vorgesehen ist, das mit dem Aktionsmodul (24) gekoppelt ist.

8. Vorrichtung nach Anspruch 6 oder 7, dadurch gekennzeichnet, daß ein Dateneingabemodul (22) zur Eingabe der Daten vorgesehen ist, das mit dem Datenverwaltungsmodul (25) gekoppelt ist.

9. Vorrichtung nach einem der Ansprüche 6 - 8, dadurch gekennzeichnet, daß ein Konfigurationseingabemodul (20) zur Eingabe der das Übermittlungssystem betreffenden Informationen vorgesehen ist, wobei das Konfigurationseingabemodul (20) mit dem Wegewahlmodul (23) gekoppelt ist.

10. Vorrichtung nach einem der Anprüche 5 - 9, dadurch gekennzeichnet, daß ein Schnittstellenmodul (26) vorgesehen ist, das mit dem Datenverwaltungsmodul (25), dem Wegewahlmodul (23) und dem Übermittlungssystem (33, 34 über 27) gekoppelt ist.
